Europäisches Patentamt

European Patent Office

Office européen des brevets

(19)

(11) Veröffentlichungsnummer: **0 250 495 B1**

(12) # EUROPÄISCHE PATENTSCHRIFT

(45) Veröffentlichungstag der Patentschrift:
27.03.91 Patentblatt 91/13

(51) Int. Cl.$^5$: **G05B 23/02, G01M 15/00**

(21) Anmeldenummer: **87900045.3**

(22) Anmeldetag: **02.12.86**

(86) Internationale Anmeldenummer:
**PCT/DE86/00494**

(87) Internationale Veröffentlichungsnummer:
**WO 87/03975 02.07.87 Gazette 87/14**

(54) VERFAHREN ZUR AUTOMATISCHEN ÜBERPRÜFUNG VON STEUERGERÄTEN.

(30) Priorität: 24.12.85 DE 3546127

(43) Veröffentlichungstag der Anmeldung:
07.01.88 Patentblatt 88/01

(45) Bekanntmachung des Hinweises auf die
Patenterteilung:
27.03.91 Patentblatt 91/13

(84) Benannte Vertragsstaaten:
DE FR GB

(56) Entgegenhaltungen:
EP-A- 0 051 861
DE-A- 2 918 956
DE-A- 3 126 231
US-A- 4 234 921
IECI, "78 Proceedings - Industrial Applications of Microprocessors, 20-22 March 1978, E. Pelta et al., "A microprocessor control automatic test & diagnostic system for use on electronic automotive engine control systems", pages 106-112

(73) Patentinhaber: ROBERT BOSCH GMBH
Postfach 50
W-7000 Stuttgart 1 (DE)

(72) Erfinder: BRAUN, Günter
Blumenstr. 15
W-7120 Bietigheim/Bissingen (DE)
Erfinder: HARSCH, Klaus
Schillerstr. 37/1
W-7257 Ditzingen 4 (DE)
Erfinder: KOSAK, Wolfgang
Mendelssohnstr. 14
W-7141 Möglingen (DE)
Erfinder: MILLER, Norbert
Schillerstr. 19/1
W-7101 Abstatt (DE)
Erfinder: ARNOLD, Herbert
Heselstr. 49
W-7147 Eberdingen (DE)

## Beschreibung

Die Erfindung betrifft ein Verfahren zur automatischen Überprüfung von unterschiedlichen Steuergeräten gemäß Gattung des Hauptanspruchs.

Bei Programm- oder Datenänderungen in einer laufenden Serie von Steuergeräten ist es zum Teil schwierig und sehr aufwendig, am Ende der Fertigung durch Messung von Betriebsparametern eindeutig das im Steuergerät enthaltende Steuerprogramm zu erkennen und eine entsprechende Prüfung der Steuergerätefunktionen durchzuführen. Dabei ist es erforderlich, entsprechend dem jeweils abgespeicherten Programm bzw. entsprechend der jeweils abgespeicherten Daten spezielle Prüfschritte und Prüfbefehle auszuführen. Dies kann jedoch nur dann in dieser Weise erfolgen, wenn das verwendete Prüfgerät bzw. das im Prüfgerät enthaltene Prüfprogramm auf die jeweilige Konfiguration des zu überprüfenden Steuergerätes abgestimmt ist.

Aus der DE-A 29 18 956 ist eine Prüfeinrichtung für Fahrzeuge bekannt geworden, wobei die Prüfeinrichtung aus mehreren Modulen besteht, von denen jedes die einem Steuergerät zugeordneten Prüfdaten gespeichert hat und ein Identifikationscode für die Prüfeinrichtung liefert. Um eine Prüfung eines Steuergerätes vorzunehmen, ist der Prüfeinrichtung jedoch mitzuteilen, welches Steuergerät mit welchen Daten und Programmen vorliegt. Aus der EP-A 51 861 ist eine unbemannte Diagnoseeinrichtung bekannt geworden, mittels der rechnergesteuerte Maschinen zu überprüfen sind. Über ein Datenkommunikationsnetz wird vom Diagnoserechner die Maschine aufgerufen, die daraufhin Identifikationsdaten an das Diagnosegerät abgibt. Dann ist das Diagnosegerät in der Lage eine Diagnose vorzunehmen. Insbesondere wenn eine schnelle Prüfung einer Vielzahl von Geräten vorzunehmen ist, ist es zeitaufwendig, wenn von der Diagnoseeinrichtung erst eine Aufforderung kommen muß, Identifizierungsdaten abzugeben.

## Vorteile der Erfindung

Das erfindungsgemäße Verfahren zur automatischen Überprüfung von Steuergeräten hat den Vorteil, daß selbsttätig unterschiedliche Steuergeräte bzw. Steuergeräte mit unterschiedlichen Steuerprogrammen automatisch von einer einzigen Prüfeinrichtung auf Funktionsfähigkeit überprüft werden können. Durch die Übertragung eines Identifikationscodes vor Beginn des Prüfvorgangs erkennt die verwendete Prüfeinrichtung, um welches Steuergerät oder um welches Steuerprogramm es sich bei dem zu überprüfenden Gerät handelt. Die Prüfeinrichtung führt dann selbsttätig die geeigneten Prüfschritte durch. Damit für die Übertragung der Daten zwischen Prüfeinrichtung und dem zu überprüfenden Steuergerät keine zusätzlichen Ein- und Ausgänge am Steuergerät erforderlich sind, erfolgt die Datenübertragung über vorhandene Eingänge und Meßausgänge. Dabei können Übertragungscodierungen gewählt werden, die im normalen Betrieb nicht auftreten können oder zumindest selbst bei gestörtem Normalbetrieb äußerst unwahrscheinlich sind.

Die Übertragung des Identifikationscode, der die Einstellung der Prüfeinrichtung auf das zu prüfende Gerät bewirkt, erfolgt bei jeder Geräteinitialisierungsphase, d.h. beim Einschalten des zu überprüfenden Steuergerätes.

Nachdem im Prüfgerät der Identifikationscode empfangen wurde, wird das Prüfprogramm gegebenenfalls so modifiziert, daß die Prüfschritte des Prüfprogramms auf das jeweils zu überprüfende Steuergerät abgestimmt sind. Die Prüfschritte werden nacheinander vom Prüfgerät aus eingeleitet, worauf jeweils vom Steuergerät rückübertragene Prüf-Antworten im Prüfgerät ausgewertet werden. Auf diese Weise können nacheinander die zu überprüfenden Funktionen abgefragt und gegebenenfalls eine Fehlererkennung am Prüfgerät ausgelöst werden.

## Zeichnung

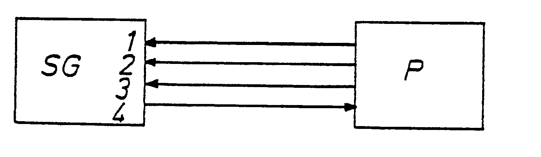

Die Erfindung wird anhand eines in der Zeichnung dargestellten Ausführungsbeispiels näher erläutert.

Das vereinfachte Blockschaltbild zeigt ein zu überprüfendes Steuergerät SG und eine Prüfeinrichtung P, die an drei Meßeingänge 1, 2, 3 und einen Ausgang 4 des Steuergerätes SG angeschlossen ist. Im Normalbetrieb sind die Meßeingänge 1 bis 3 mit verschiedenen Gebern verbunden. So kann beispielsweise am Meßeingang 1 die Motortemperatur, am Meßeingang 2 die Luftmenge und am Meßeingang 3 die Drehzahl dem Steuergerät SG zugeführt werden. Oer Ausgang 4 kann im Betrieb ohne Bedeutung sein, während bei der automatischen Überprüfung des Steuergerätes SG über den Ausgang 4 die Ausgabe der Code-Worte zur Prüfeinrichtung P erfolgt. Zur Initialisierung und Durchführung der verschiedenen Prüfschritte kann von der Prüfeinrichtung P eine im Betrieb nicht vorkommende Kombination von Daten zum Steuergerät SG übertragen werden. Beispielsweise können an die Meßeingänge 1 bis 3 folgende Daten bzw. Signale zur Einleitung des prüfverfahrens übertragen werden :

    Meßeingang 1 : Motortemperatur > 160°C

    Meßeingang 2 : Luftmenge = 0 m³/h

    Meßeingang 3 : Drehzahl = 25.000 1/min

Durch die Eingabe dieser Datenkombination wird das Steuergerät SG veranlaßt, am Ausgang 4 den Identifikationscode und gegebenenfalls weitere Code-Wörter zur Prüfeinrichtung P zu übertragen. Die Prüfeinrichtung P kann dann die erforderlichen Prüfschritte zur automatischen Überprüfung des Steuergerätes SG durchführen.

## Ansprüche

1. Verfahren zur automatischen Überprüfung von unterschiedlichen Steuergeräten durch eine einzige Prüfeinrichtung, welche Steuergeräte jeweils wenigstens einen Daten- und/oder Programmspeicher enthalten, bei welchem Verfahren aus dem Speicher eines zu überprüfenden Steuergerätes ein das Steuergerät (SG) oder dessen Programm kennzeichnender Identifikationscode abgegeben wird und aufgrund des abgegebenen Identifikationscodes die Prüfeinrichtung die für dieses Steuergerät geeigneten Prüfschritte selbsttätig durchführt, dadurch gekennzeichnet, daß beim Einschalten des zu überprüfenden Steuergeräts dessen Identifikationscode an die Prüfeinrichtung automatisch abgegeben wird und daß zur Abgabe des Identifikationscodes ein bei normalem Betrieb des Steuergerätes benutzter Steuergeräteausgang verwendet wird.

2. Verfahren nach Anspruch 1, dadurch gekennzeichnet, daß in der Geräteinitialisierungsphase immer zunächst der Identifikationscode abgegeben wird.

3. Verfahren nach Anspruch 1, dadurch gekennzeichnet, daß die Prüfeinrichtung (P) an weinigstens einen Meßeingang (1, 2, 3) des Steuergeräts (SG) einen im normalen Betrieb nicht möglichen Initialisierungscode überträgt, der das Prüfverfahren einleitet und die Rückübertragung des Identifikationscodes veranlaßt.

4. Verfahren nach Anspruch 3, dadurch gekennzeichnet, daß der Initialisierungscode an einem in Betrieb weniger bedeutenden Meßeingang in das Steuergerät (SG) eingespeist wird.

5. Verfahren nach Anspruch 3, dadurch gekennzeichnet, daß der Initialisierungscode an einem im Betrieb nicht benötigten Meßeingang in das Steuergerät (SG) eingespeist wird.

6. Verfahren nach einem der vorhergehenden Ansprüche, dadurch gekennzeichnet, daß nach Einleitung des prüfverfahrens die einzelnen Prüfschritte von der Prüfeinrichtung (P) eingeleitet werden.

7. Verfahren nach einem der vorhergehenden Ansprüche, dadurch gekennzeichnet, daß über einen im Betrieb nicht benötigten Meßausgang (4) der Identifikationscode zur Prüfeinrichtung (P) übertragen wird.

## Claims

1. Process for automatically testing different control devices by a single test device, which control devices contain in each case at least one data and/or program memory, in which process an identification code identifying the control device (SG) or its program is output from the memory of a control device to be tested and, on the basis of the identification code output, the test device automatically executes the appropriate testing steps for this control device, characterized in that, when the control device to be tested is switched on, its identification code is automatically output to the test device, and in that a control device output which is used during normal operation of the control device is used for outputting the identification code.

2. Process according to Claim 1, characterized in that the identification code is always output first of all in the device initialization phase.

3. Process according to Claim 1, characterized in that, at at least one measurement input (1, 2, 3) of the control device (SG), the test device (P) transmits an initialization code which is not possible during normal operation which initiates the test process and triggers the return transmission of the identification code.

4. Process according to Claim 3, characterized in that the initialization code is fed into the control device (SG) at a measurement input which is of lesser significance during operation.

5. Process according to Claim 3, characterized in that the initialization code is fed into the control device (SG) at a measurement input which is not required during operation.

6. Process according to one of the preceding claims, characterized in that, after initiation of the test process, the individual testing steps are initiated by the test device (P).

7. Process according to one of the preceding claims, characterized in that the identification code is transmitted to the test device (P) via a measurement output (4) which is not required during operation.

## Revendications

1. Procédé pour le contrôle automatique de différents appareils de commande par un dispositif de contrôle unique, ces appareils de commande contenant respectivement chacun au moins une mémoire de données et/ou une mémoire de programme, procédé dans lequel à partir de la mémoire d'un appareil de commande à contrôler, un code d'identification caractérisant l'appareil de commande (SG) ou bien son programme, est délivré, et sur la base du code d'identification ainsi délivré, le dispositif de contrôle effectue automatiquement les étapes de contrôle appropriées pour cet appareil de commande, procédé caractérisé en ce que lors de la mise en circuit de l'appareil de commande à contrôler, son code d'identification est automatiquement délivré au dispositif de contrôle et en ce que pour délivrer le code d'identification, une sortie de l'appareil de commande, utilisée en fonctionnement normal de cet appareil de commande, est utilisée.

2. Procédé selon la revendication 1, caractérisé en ce que dans la phase d'initialisation de l'appareil, le code d'identification est toujours délivré en premier lieu.

3. Procédé selon la revendication 1, caractérisé en ce que le dispositif de contrôle (P) transmet à au moins une entrée de mesure (1, 2, 3) de l'appareil de commande (SG) un code d'initialisation non possible en fonctionnement normal, qui met en route le processus de contrôle et permet la retransmission du code d'identification.

4. Procédé selon la revendication 3, caractérisé en ce que le code d'initialisation est introduit dans l'appareil de commande (SG) sur une entrée de mesure de peu d'importance pendant le fonctionnement.

5. Procédé selon la revendication 3, caractérisé en ce que le code d'initialisation est introduit dans l'appareil de commande (SG) sur une entrée de mesure non utilisée au cours du fonctionnement.

6. Procédé selon une des précédentes revendications, caractérisé en ce que, après la mise en route du processus de contrôle, les différents étapes de contrôle sont mises en route par le dispositif de contrôle (P).

7. Procédé selon une des précédentes revendications, caractérisé en ce que le code d'identification pour le dispositif de contrôle (P) est transmis par l'intermédiaire d'une sortie de mesure (4) non utilisée pendant le fonctionnement.

SG

1
2
3
4

P